Europäisches Patentamt

(19) European Patent Office

Office européen des brevets

(11) Numéro de publication : **0 030 186**
**B1**

(12) **FASCICULE DE BREVET EUROPÉEN**

(45) Date de publication du fascicule du brevet :
01.06.83

(51) Int. Cl.³ : **G 01 R  1/20, H 01 C  3/02**

(21) Numéro de dépôt : **80401670.7**

(22) Date de dépôt : **21.11.80**

(54) Shunt de mesure à compensation de tension d'erreur induite.

(30) Priorité : **28.11.79 FR 7929222**

(43) Date de publication de la demande :
**10.06.81 Bulletin 81/23**

(45) Mention de la délivrance du brevet :
**01.06.83 Bulletin 83/22**

(84) Etats contractants désignés :
**AT BE CH DE FR GB IT LI NL SE**

(56) Documents cités :
**DE B 1 216 981**
**FR A 2 348 498**

(73) Titulaire : **ENERTEC SOCIETE ANONYME**
**12, Place des Etats-Unis**
**F-92120 Montrouge (FR)**

(72) Inventeur : **Ley, Antony**
**10, rue de Creuse Voie**
**F-91570 Bièvres (FR)**
Inventeur : **Allesch, Roland**
**22, rue de Ricquebourg**
**F-92160 Antony (FR)**
Inventeur : **Bazin, Alain**
**8, Allée Berlioz**
**F-94800 Villejuif (FR)**

(74) Mandataire : **Bentz, Jean-Paul**
**GIERS SCHLUMBERGER Service BREVETS**
**12, place des Etats-Unis**
**F-92124 Montrouge Cedex (FR)**

## Shunt de mesure à compensation de tension d'erreur induite

La présente invention concerne un shunt de mesure comprenant :

— une résistance pourvue d'une première et d'une seconde borne d'amenée de courant ainsi qu'une première et une seconde borne de prélèvement de tension,

— une inductance,

— et une première et seconde borne de mesure de tension,

ladite résistance étant destinée à fournir entre les bornes de prélèvement de tension une tension représentative du courant la traversant, et ladite inductance étant destinée à fournir, en présence d'un champ magnétique variable parasite, une tension induite compensant la tension induite dans ladite résistance, et étant connectée au moins à l'une des bornes de prélèvement de tension et à l'une des bornes de mesure de façon qu'apparaisse en les bornes de mesure une tension exempte de tension d'erreur induite.

Un tel shunt de mesure, utilisant une résistance et une inductance associée, en vue de fournir une tension image d'un courant et exempte de tension d'erreur induite est notamment décrit dans le brevet allemand DE-B 1 216 981.

Cependant les shunts connus de ce type ne sont pas conçus pour être protégés des champs magnétiques environnants, mais pour être protégés du champ créé par le courant les traversant ; c'est ainsi que ces shunts, qui adoptent une configuration axiale, sont, en raison de la complexité de leur structure et de leur coût, réservés à des applications de laboratoire ou relativement sophistiquées.

Par ailleurs le développement industriel relativement récent de compteurs d'énergie électrique ayant recours aux techniques électroniques a fait apparaître l'utilisation de shunts classiques dépourvus de compensation de la tension d'erreur induite, destinés à délivrer une tension représentative du courant qui les traverse. Par exemple, le demandeur a développé des shunts produisant une tension type d'environ 5 mV pour un courant de 20 A, ainsi que des shunts produisant une tension type de 7 mV environ pour un courant de 100 A.

Cependant de tels shunts sont, dans leurs conditions d'utilisation, soumis à des champs magnétiques alternatifs tels que peuvent en produire par exemple des circuits de distribution d'énergie voisins et/ou des portions voisines du circuit de distribution dans lequel ils sont branchés, et font apparaître entre leurs bornes une tension induite parasite qui se superpose à la tension représentative du courant et constitue un signal d'erreur.

Le demandeur a observé qu'un champ magnétique alternatif d'environ 5 Oersteds, par exemple, perpendiculaire au plan moyen d'un tel shunt était susceptible d'induire une tension parasite pouvant atteindre 50 µV qui représente une erreur d'environ 1 % de l'amplitude de pleine échelle de la tension représentative du courant. Des erreurs de cet ordre sont inacceptables dans les compteurs d'énergie.

Dans ce contexte, la présente invention a pour but de proposer un shunt de mesure à compensation de tension d'erreur induite, de structure simple et de conception industrielle, susceptible d'être produit en masse à un prix de revient relativement faible, en particulier pour son application aux compteurs d'énergie électrique ayant recours aux techniques électroniques.

Le shunt de mesure de la présente invention présente la structure telle qu'énoncée dans la revendication 1.

Selon une première forme de réalisation de l'invention, la boucle ouverte constitue un chemin électrique ininterrompu entre ses première et seconde extrémités, la seconde extrémité de cette boucle est électriquement connectée à la seconde borne de prélèvement de tension, et les première et seconde bornes de mesure sont respectivement raccordées ou constituées par la première borne de prélèvement de tension et la première extrémité de cette boucle.

Avantageusement, selon cette première forme de réalisation, l'inductance comprend deux boucles ouvertes en forme de U placées face à face sur les faces opposées de la plaque constituant la résistance, ces deux boucles ouvertes étant physiquement reliées par leurs premières et secondes extrémités respectives pour constituer un cavalier d'une seule pièce. Par exemple, le cavalier formant l'inductance est constitué d'un matériau ressort électriquement conducteur tel qu'un alliage bronze-béryllium, qui vient se pincer sur la plaque.

Selon un second mode de réalisation de l'invention, mieux adapté encore aux exigences industrielles de fabrication, la boucle ouverte est constituée par deux portions convergentes de deux conducteurs électriques différents isolés l'un de l'autre, la première portion ayant une extrémité électriquement connectée à la première borne de prélèvement de tension, la seconde portion ayant une extrémité électriquement connectée à la seconde borne de prélèvement de tension et les portions de conducteurs convergeant l'une vers l'autre en direction opposée de leurs extrémités raccordées aux bornes de tension. De préférence, lesdites portions de conducteurs sont disposées d'un même côté de la plaque et se rejoignent en un point commun situé au voisinage du bord de la plaque qui est opposé à celui sur lequel sont disposées lesdites bornes de tension, lesdits conducteurs isolés se prolongent, et sont torsadés ensemble, au-delà dudit point commun et lesdites bornes de mesure sont constituées par deux points respectifs desdits conducteurs torsadés. Avantageusement, ladite boucle ouverte est appliquée sur une face de ladite plaque au moyen d'un agent adhésif.

En outre, quel que soit le mode de réalisation, il est commode et efficace de donner à la plaque qui constitue la résistance une forme sensiblement rectangulaire, cette plaque étant par exemple formée de manganin.

L'invention va maintenant être décrite à titre d'exemple non limitatif en référence aux dessins annexés sur lesquels :

la figure 1 est une vue en plan d'un shunt suivant un premier mode de réalisation de la présente invention ;

la figure 2 représente une section agrandie selon la ligne 2.2 de la figure 1 ;

la figure 3 est une vue en plan d'une ébauche estampée pour fabriquer l'inductance incorporée au shunt de la figure 1 ;

la figure 4 est une vue en plan d'un shunt suivant un second mode de réalisation de la présente invention ;

la figure 5 est une vue en coupe du shunt de la figure 4, vu suivant les flèches 5.5 de cette figure.

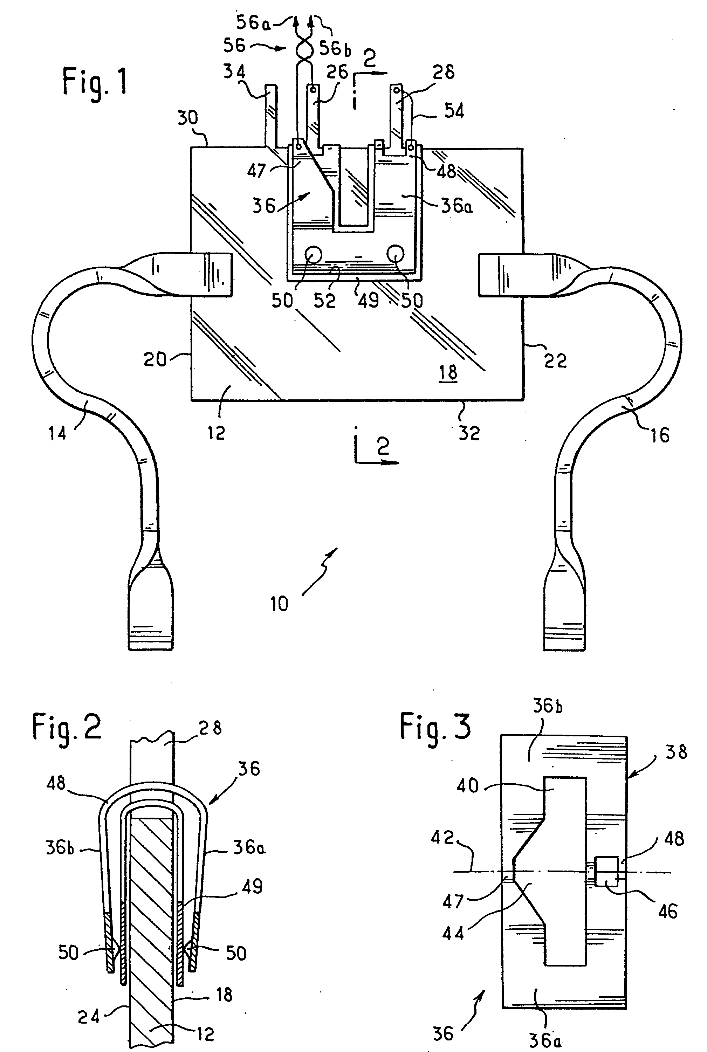

Le shunt illustré aux figures 1, 2, 4 et 5 est désigné d'une façon générale en 10 et comporte une résistance formée d'une plaque sensiblement rectangulaire 12, par exemple d'environ 4 cm de long, 3 cm de large et 2 mm d'épaisseur, constituée par un manganin commercialisé sous le nom de « Manganine 42 ». Le shunt 10 possède un conducteur d'entrée 14 et un conducteur de sortie 16 qui sont brasés sur l'une des faces 18 de la plaque 12 au voisinage des milieux des deux côtés courts 20 et 22 de celui-ci. Les conducteurs 14 et 16 sont formés à partir de barres de cuivre relativement épaisses, (par exemple de 7 mm par 3 mm de section), sectionnées pliées et tordues de manière convenable, et sont brasés sur la plaque 12 en utilisant un amalgame de brasure argent-phosphore (AgP) selon une technique de chauffage par résistance électrique ; selon cette technique, un courant relativement élevé est envoyé pendant quelques secondes entre, d'une part, une première électrode de carbone appliquant les extrémités respectives 14 et 16 contre une épaisse couche de l'amalgame sur la face 18 de la plaque 12, et, d'autre part, une seconde électrode de carbone appliquée contre l'autre face 24 de la plaque 12.

La plaque 12 comporte des première et seconde bornes de tension 26, 28 qui se projettent, dans le plan de cette plaque, à partir de l'un de ses deux grands côtés 30, 32. Ainsi qu'on peut le voir sur la figure 1, les bornes 26, 28 se projettent à partir du côté 30 de façon sensiblement symétrique de part et d'autre du milieu du côté 30. Une troisième borne 34 qui est utilisée comme borne d'alimentation, comme il sera expliqué ci-après, se projette à partir du côté 30 de la plaque 12 au voisinage de la borne 26.

Le shunt 10 peut être utilisé comme élément d'un compteur d'énergie électrique de type électronique et être branché en série avec le (ou un) fil actif du circuit de distribution d'énergie électrique dans lequel le compteur est branché. Le courant circulant dans le fil actif, qui peut avoir une valeur maximale de 100 A, entre et sort de la plaque 12 par l'intermédiaire des conducteurs 14 et 16, respectivement, et provoque l'apparition d'une tension proportionnelle à ce courant entre la première et la deuxième borne de tension 26, 28. Cette tension peut être de 7 mV par exemple pour un courant de 100 A, et peut être ajustée préalablement par une opération d'étalonnage au cours de laquelle une petite quantité du matériau de la plaque 12 est éliminée progressivement par perçage entre les bornes 26 et 28, au voisinage du bord 30, pendant qu'un courant déterminé avec précision, par exemple 100 A, traverse le shunt, jusqu'à ce que la tension entre les bornes 26, 28 atteigne la valeur désirée.

La tension représentative du courant qui apparaît entre les bornes 26 et 28 est appliquée au circuit électronique du compteur en tant que signal de donnée destiné à être traité par celui-ci. Le conducteur de retour (ou zéro volt) de l'alimentation du circuit est relié à la borne d'alimentation 34 du shunt 10 pour assurer que le courant utilisé par le circuit ne traverse pas les bornes 26 et 28 et par conséquent n'affecte pas la tension d'entrée appliquée au circuit de traitement.

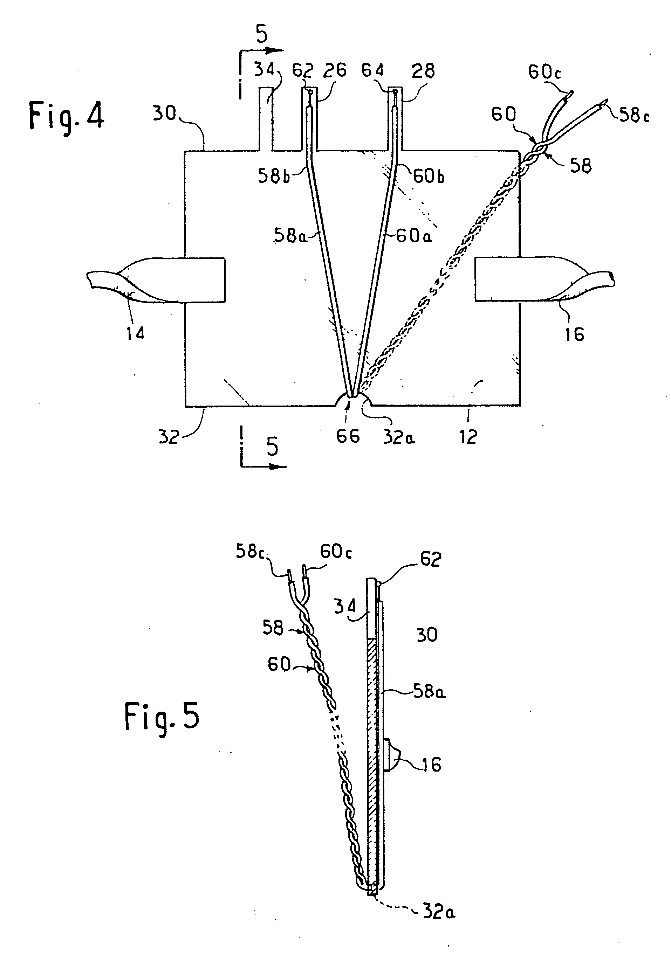

Cependant, comme indiqué précédemment, si le shunt 10 est soumis à un champ magnétique alternatif possédant une composante perpendiculaire au plan de la plaque 12, une tension parasite est induite dans cette plaque, entre les bornes 26 et 28, et cette tension parasite peut atteindre 50 µV pour un champ de 5 Oersteds. Pour compenser cette tension parasite, le shunt de l'invention comprend une inductance de compensation essentiellement constituée par une ou plusieurs boucles ouvertes telle que 36a ou 36b sur les figures 1 à 3, ou telle que celle qui est formée par la combinaison de 58a et 60a sur la figure 4, chaque boucle étant, au moins partiellement, constituée d'un matériau électriquement conducteur.

Chaque boucle ouverte comprend une première extrémité, telle que 47 sur la figure 1 ou 58b sur la figure 4, qui est disposée au voisinage de la borne de tension 26, et une seconde extrémité, telle que 48 sur la figure 1 ou 60b sur la figure 4, qui est disposée au voisinage de la borne de tension 28.

Entre ses deux extrémités, la boucle s'étend, au moins approximativement, dans un plan de même direction que la surface de la plaque, le plus près possible de cette surface et vers l'intérieur de cette surface par rapport au bord 30, c'est-à-dire en s'approchant du bord 32 opposé au bord 30. Les dimensions et la forme de la ou des boucles ouvertes de compensation sont choisies pour constituer une inductance égale (mais de signe opposé) à celle que constitue entre les bornes 26 et 28, la plaque 12 soumise à un champ magnétique. Ce choix de dimensions et de forme peut aisément être conduit, une fois pour toutes, par tâtonnement, en plaçant la plaque 12 et sa ou ses boucles de compensation dans un champ magnétique alternatif, en mesurant continûment l'inductance de la plaque et celle de la boucle, et en modifiant la forme et/ou les dimensions de la boucle pour obtenir l'égalité de ces inductances.

Selon un premier mode de réalisation de l'invention, (Fig. 1 à 3), il est prévu deux boucles ouvertes 36a et 36b constituées par un organe de compensation 36 adoptant sensiblement la forme d'un cavalier qui vient se pincer par dessus le côté 30 de la plaque 12 dans la région des bornes 26, 28, 34. Cet organe 36 est fabriqué par estampage et pliage comme suit. Une ébauche initiale 38 de forme générale rectangulaire telle qu'illustrée par la figure 3 est produite par estampage d'une feuille d'un matériau ressort électriquement conducteur tel qu'un alliage bronze-béryllium. L'ébauche 38 présente une ouverture généralement rectangulaire 40, symétrique par rapport à une ligne 42, joignant les milieux de ces deux grands côtés. L'un des bords de cette ouverture 40 possède une partie découpée 44, également symétrique par rapport à la ligne 42, tandis qu'une ouverture beaucoup plus petite 46 également symétrique par rapport à la ligne 42 est prévue dans l'ébauche 38, du côté opposé de l'ouverture 40 par rapport à la portion découpée 44. L'ébauche 38 est pliée en deux moitiés le long de la ligne 42 pour former l'organe en forme de cavalier 36.

Cet organe 36 consiste donc en deux portions en forme de U, 36a et 36b, placées en vis-à-vis et qui sont reliées par les sommets 47, 48 des bras correspondants de leur profil en U pour former un clip à ressort qui peut être monté à cheval sur le côté 30 pour pincer la plaque 12. La découpe 44 et l'ouverture 46 permettent le passage des bornes 26 et 28 respectivement. En outre, une couche 49 d'un matériau isolant tel que du papier est interposée entre l'organe 36 et la plaque 12 pour les isoler l'un de l'autre. Afin d'éviter que les bords éventuellement acérés de l'organe 36 ne coupent la couche 49 de matériau isolant, plusieurs bosses convexes lisses 50 sont formées sur les surfaces de l'organe 36 qui s'appuient sur la couche 49, par poinçonnage de cuvettes à la surface de l'ébauche 38 qui est destinée à constituer la surface extérieure de l'organe 36 après pliage.

Pour ajuster l'organe 36 sur la plaque 12, on revêt la partie correspondante de cette plaque d'un agent adhésif convenable, par exemple une résine époxyde, puis on applique la couche 49 de matériau isolant. Après application d'une nouvelle couche d'agent adhésif, l'organe 36 est placé de façon à pincer la couche 49, la position exacte de la bordure inférieure 52 de l'organe 36 par rapport au côté 32 de la plaque 12 étant déterminée par un accessoire de montage (non représenté) qui est pincé sur la plaque du côté 32. Enfin, une autre couche d'agent adhésif est appliquée sur l'organe 36.

Par sa forme, l'organe 36 constitue deux boucles ouvertes d'inductance connectées en parallèle, leurs dimensions étant choisies pour fournir une valeur d'inductance effective entre les sommets 47 et 48 des bras du U équivalente à celle de la plaque 12. A titre d'exemple, l'organe en forme de cavalier 36 peut avoir les dimensions types suivantes : 1,5 cm de haut sur 1,5 cm de large avec un espace de 0,5 cm entre les bras.

Du fait qu'en raison de sa position, l'organe 36 est soumis sensiblement au même champ magnétique que la plaque 12, une tension sensiblement égale à la tension parasite induite entre les bornes de tension 26 et 28 de la plaque 12 se trouve induite entre les sommets respectifs 47, 48 des bras du cavalier 36.

En reliant électriquement la borne 28 au sommet 48 du bras voisin de l'organe 36 par l'intermédiaire d'un fil de liaison 54 et en prélevant la tension de sortie du shunt 10 entre les extrémités libres 56a, 56b, constituant les bornes de mesure, d'une paire de conducteurs torsadés 56 connectés l'un à la borne 26 et l'autre au sommet 47 de l'autre bras de l'organe 36, la tension induite dans l'organe 36 annule sensiblement, ou s'oppose à, la tension parasite induite entre les bornes de tension 26, 28. La demanderesse a constaté que la tension parasite de 50 µV mentionnée précédemment peut être réduite par un facteur de plus de dix à l'aide de l'organe 36. Dans ce mode de réalisation, l'extrémité libre 56a et le sommet 47 de l'organe 36 peuvent être tous deux considérés comme l'une des bornes de mesure, l'autre étant constituée indifféremment par l'extrémité 56b ou la borne de tension 26.

Selon un second mode de réalisation de l'invention, de mise en œuvre plus simple, il est prévu une seule boucle ouverte, constituée par deux portions convergentes 58a, 60a, de deux conducteurs électriques différents isolés l'un de l'autre 58, 60. Une extrémité 58b de la portion de conducteur 58a est soudée à la borne de tension 26 du shunt en un point 62, une extrémité 60b de la portion de conducteur 60a est soudée à la borne de tension 28 en un point 64, et les portions de conducteurs 58a et 60a convergent l'une vers l'autre en direction opposée de leurs extrémités 58b et 60b, vers un point commun 66, ce point commun étant disposé au voisinage du bord 32 de la plaque 12 qui est opposé au bord 30 portant les bornes de tension 26 et 28. Pour permettre une bonne tenue des portions de conducteurs 58a et 60a, une encoche 32a peut être pratiquée dans le bord 32 de la plaque 12, cette encoche maintenant en place le point de jonction 66 des portions de conducteurs 58a et 60a.

On remarquera que dans ce second mode de réalisation, contrairement au cas du premier mode, la boucle ouverte 58a, 60a, bien qu'essentiellement constituée d'un matériau électriquement conducteur, ne forme pas un chemin électrique ininterrompu entre ses extrémités 58b et 60b. En effet, les conducteurs 58 et 60 étant isolés, les portions 58a et 60a sont non seulement toutes deux isolées de la plaque 12, mais également isolées l'une de l'autre, y compris à leur point de rencontre 66 dans l'encoche 32a.

Au-delà du point de rencontre 66 des portions 58a et 60a, les conducteurs isolés 58 et 60 sont torsadés ensemble et la tension représentative du courant à mesurer entre les bornes 26 et 28 est prélevée entre les extrémités libres 58c et 60c des conducteurs 58 et 60, qui constituent donc les bornes de mesure du shunt.

Selon ce second mode de réalisation, la boucle ouverte adopte assez typiquement la forme d'un V, donc une forme assez voisine de celle des boucles 36a ou 36b du premier mode de réalisation. Toutefois il n'est pas exclu de pouvoir trouver, par tâtonnement comme indiqué précédemment, des variations sensibles de cette forme en V, sans modifier le résultat recherché.

La forme et les dimensions de cette boucle ayant été déterminées une fois pour toutes, il est commode de maintenir cette dernière en place sur une face de la plaque 12 au moyen d'un agent adhésif.

De nombreuses modifications peuvent être apportées aux modes de réalisation décrits sans sortir pour autant du cadre de la présente invention.

En particulier, dans des modes de réalisation dérivés du premier mode décrit, l'organe 36 peut être constitué par une seule boucle ouverte formée par un fil convenablement fixé à une face de la plaque 12 et isolé de celle-ci, ou encore par une plaque pratiquement identique à la plaque 12, également fixée à l'une des faces de la plaque 12 et isolée de cette dernière et comportant des bornes 26a et 28a correspondant respectivement aux bornes 26 et 28 de la plaque 12, les bornes 28 et 28a étant reliées électriquement, et les bornes 26 et 26a pouvant être considérées comme constituant les bornes de mesure du shunt ou étant reliées par des conducteurs torsadés tels que les conducteurs 56 de la figure 1, à des bornes de mesure telles que 56a, 56b.

Selon un autre mode de réalisation, l'inductance de compensation est formée dans la plaque 12 elle-même. A cette fin, la plaque 12 est repliée sur elle-même suivant la ligne 2.2 de la figure 1, les faces des deux moitiés de plaque repliées l'une sur l'autre étant électriquement isolées l'une de l'autre et les bornes 26 et 28 pouvant être considérées comme constituant des bornes de mesure ou étant reliées par des conducteurs torsadés tels que 56 (fig. 1), à des bornes de mesure telles que 56a, 56b.

Dans ce dernier mode de réalisation, ainsi que dans celui utilisant une plaque semblable à la plaque 12, aucun ajustement de la forme et des dimensions de la boucle n'est à réaliser. Il convient cependant de noter que le dernier mode de réalisation cité, bien qu'à priori le plus simple, n'est applicable qu'aux plaques 12 relativement minces et nécessite un traitement thermique de cette plaque après pliage en vue de restituer à cette dernière sa structure cristalline initiale.

**Revendications**

1. Shunt de mesure comprenant :
— une résistance (12) pourvue d'une première et d'une seconde borne (14, 16) d'amenée de courant ainsi qu'une première et une seconde borne (26, 28) de prélèvement de tension,
— une inductance (36 ou 58a, 60a),
— et une première et seconde borne (56a 56b, ou 58c, 60c) de mesure de tension,
ladite résistance (12) étant destinée à fournir entre les bornes de prélèvement de tension (26, 28) une tension représentative du courant la traversant, et ladite inductance (36 ou 58a, 60a) étant destinée à fournir, en présence d'un champ magnétique variable parasite, une tension induite compensant la tension induite dans ladite résistance, et étant connectée au moins à l'une des bornes de prélèvement de tension (26, 28) et à l'une des bornes de mesure de façon qu'apparaisse entre les bornes de mesure (56a, 56b ou 58c, 60c) une tension exempte de tension d'erreur induite, caractérisée en ce que ladite résistance (12) est essentiellement constituée par une plaque d'un matériau électriquement conducteur, en ce que les première et seconde bornes (26, 28) de prélèvement de tension sont disposées sur un même bord (30) de cette plaque en des points espacés l'un de l'autre, en ce que ladite inductance (36 ou 58a, 60a) comprend au moins une boucle ouverte (36a ou 36b ou 58a, 60a) formée d'un matériau électriquement conducteur et s'étend à partir de ses première et seconde extrémités (47, 48 ou 58b, 60b) respectivement disposées au voisinage des première et seconde bornes (26, 28) de prélèvement de tension, vers l'intérieur de la surface de cette plaque et dans un plan au moins approximativement parallèle à celle-ci et en ce que la résistance et l'inductance sont, en dehors dudit branchement de l'inductance sur la première au moins desdites bornes de prélèvement de tension, électriquement isolées l'une de l'autre.

2. Shunt suivant la revendication 1, caractérisé en ce que ladite boucle ouverte constitue un chemin électrique ininterrompu entre ses première et seconde extrémités (47, 48), en ce que la seconde extrémité (48) de cette boucle est électriquement connectée à ladite seconde borne (28) de prélèvement de tension, et en ce que lesdites première et seconde bornes de mesure (56a, 56b) sont respectivement raccordées à ou constituées par ladite première borne (26) de prélèvement de tension et la première extrémité (47) de cette boucle.

3. Shunt suivant la revendication 1 ou 2, caractérisé en ce que l'inductance comprend deux boucles ouvertes en forme de (36a, 36b) placées face à face sur les faces opposées de ladite plaque (12) constituant la résistance, ces deux boucles ouvertes étant physiquement reliées par leurs premières et secondes extrémités respectives (47, 48) pour constituer un cavalier d'une seule pièce.

4. Shunt suivant la revendication 3, caractérisé en ce que le cavalier formant l'inductance est constitué d'un matériau ressort électriquement conducteur qui vient se pincer sur la plaque (12).

5. Shunt suivant la revendication 4, caractérisé en ce que ledit matériau ressort est un alliage bronze-béryllium.

6. Shunt suivant la revendication 1, caractérisé en ce que ladite boucle ouverte est constituée par deux portions convergentes (58a, 60a) de deux conducteurs électriques différents isolés l'un de l'autre (58, 60), la première portion (58a) ayant une extrémité (58b) électriquement connectée à ladite première borne de prélèvement de tension (26), la seconde portion (60a) ayant une extrémité (60b) électriquement connectée à ladite seconde borne de prélèvement de tension (28) et lesdites portions de conducteurs convergeant l'un vers l'autre en direction opposée de leurs extrémités raccordées aux bornes de prélèvement de tension.

7. Shunt suivant la revendication 6, caractérisé en ce que lesdites portions de conducteurs isolés (58a, 60a) sont disposées d'un même côté de la plaque et se rejoignent en un point commun (66) situé au voisinage du bord (32) de la plaque qui est opposé à celui (30) sur lequel sont disposés lesdites bornes de tension, en ce que lesdits conducteurs isolés (58, 60) se prolongent, et sont torsadés ensemble, au-delà dudit point commun (66), et en ce que lesdites bornes de mesure sont constituées par deux points respectifs (58c, 60c) desdits conducteurs torsadés.

8. Shunt suivant l'une quelconque des revendications précédentes, caractérisé en ce que ladite plaque (12) constituant la résistance a une forme sensiblement rectangulaire.

9. Shunt suivant l'une quelconque des revendications précédentes, caractérisé en ce que au moins ladite première boucle ouverte est appliquée sur une face de ladite plaque au moyen d'un agent adhésif.

**Claims**

1. A measurement shunt comprising :
— a resistance (12) provided with first and second current supply terminals (14, 16) and with first and second voltage terminals (26, 28),
— an inductance (36 or 58a, 60a),
— and first and second voltage measurement terminals (56a, 56b, or 58c, 60c) wherein said resistance (12) is intended to provide between the voltage terminals (26, 28) a voltage representative of the current flowing through it, and said inductance (36 or 58a, 60a) is intended to provide, in the presence of a spurious variable magnetic field, an induced voltage which compensates the voltage induced in said resistance, and is connected to at least one of the voltage terminals (26, 28) and to one of the measurement terminals so that a voltage free of induced error voltage is produced between the measurement terminals (56a, 56b or 58c, 60c), characterized in that said resistance (12) is substantially formed by a plate of electrically conductive material, the first and second voltage terminals (26, 28) are disposed on the same edge (30) of the plate at spaced apart points thereon, and said inductance (36 or 58a, 60a) comprises at least one open loop (36a, or 36b or 58a, 60a) formed from an electrically conductive material extending from its first and second ends (47, 48 or 58b, 60b) respectively disposed in the vicinity of the first and second voltage terminals (26, 28), towards the interior of the surface of said plate in a plane at least approximatively parallel to the latter, and the resistance and inductance are, apart from said connection of the inductance to at least the first of said voltage terminals, electrically insulated from each other.

2. A shunt according to claim 1, characterized in that said open loop forms and ininterrupted electrical path between its first and second ends (47, 48), the second end (48) of this loop is electrically connected to said second voltage terminal (28), and the first and second measurement terminals (56a, 56b) are respectively connected to or constituted by said first voltage terminal (26) and the first end (47) of this loop.

3. A shunt according to claim 1 or claim 2, characterized in that the inductance comprises two U-shaped open loops (36a, 36b) disposed on opposite faces of the plate (12) forming the resistance, these two open loops being physically connected by their respective first and second ends (47, 48) to form a one-piece rider.

4. A shunt according to claim 3, characterized in that the rider forming the inductance is made from an electrically conductive spring material which clips onto the plate (12).

5. A shunt according to claim 4, characterized in that said spring material is a bronze-beryllium alloy.

6. A shunt according to claim 1, characterized in that the open loop is formed by two converging portions (58a, 60a) of two different electrical conductors insulated from each other (58, 60), the first portion (58a) having one end (58b) electrically connected to said first voltage terminal (26), the second portion (60a) having one end (60b) electrically connected to said second voltage terminal (28), and the portions converging towards each other in the direction away from the ends connected to the voltage terminals.

7. A shunt according to claim 6, characterized in that said insulated conductor portions (58a, 60a) are disposed on the same side of the plate and meet at a common point (66a near the edge (38) of the plate opposite the edge (30) on which the said voltage terminals are disposed, said insulated conductors (58, 60) extend from this common point (66) as a twisted pair, and said measurement terminals are constituted by two respective points (58c, 60c) of said twisted conductors.

8. A shunt according to any one of the preceding claims, characterized in that said plate (12) forming the resistance is substantially rectangular.

9. A shunt according to any one of the preceding claims, characterized in that said at least one open loop is bonded to one face of the plate by an adhesive.

## Ansprüche

1. Meßwiderstand, bestehend aus
— einem Widerstand (12), der mit einer ersten und mit einer zweiten Stromzuführungsklemme (14, 16) und ebenso mit einer ersten und einer zweiten Spannungsabgreifklemme (26, 28) versehen ist,
— einer Induktivität (36 oder 58a, 60a)
— und einer ersten und zweiten Spannungsmeßklemme (56a, 56b oder 58c, 60c),
welcher Widerstand dazu bestimmt ist, zwischen den Spannungsabgreifklemmen (26, 28) eine Spannung zu liefern, die den ihn durchfließenden Strom repräsentiert, und die besagte Induktivität dazu bestimmt ist, bei Vorhandensein eines sich ändernden parasitären Magnetfeldes eine induzierte Spannung zu liefern, die die im besagten Widerstand induzierte Spannung kompensiert, welche Induktivität mit wenigstens einer der Spannungsabgreifklemmen (26, 28) und einer der Meßklemmen derart verbunden ist, daß zwischen den Meßklemmen (56a, 58b oder 58c, 60c) eine Spannung auftritt, die frei von der induzierten Fehlerspannung ist, dadurch gekennzeichnet, daß derobgenannte Widerstand (12) im wesentlichen von einer Platte aus elektrisch leitendem Material gebildet ist, daß die ersten und zweiten Spannungsabgreifklemmen (26, 28) auf einer Seite (30) dieser Platte an zwei voneinander distanzierten Punkten angeordnet sind, daß die besagte Induktivität (36 oder 58a, 60a) aus wenigstens einer offenen Schleife (36a oder 36b oder 58a, 60a) aus einem elektrisch leitenden Material besteht und sich, ausgehend von ihren ersten und zweiten Enden (47, 48 oder 58b, 60b), die in der Nähe der ersten und zweiten Spannungsabgreifklemmen (26, 28) angeordnet sind, gegen das Innere dieser Platte und in einer Ebene, die wenigstens angenähert parallel zu dieser ist, erstreckt, und daß der Widerstand und die Induktivität, abgesehen von dem vorgenannten Anschluß der Induktivität an wenigstens die ersten der vorgenannten Spannungsabgreifklemmen, voneinander isoliert sind.

2. Meßwiderstand nach Anspruch 1, dadurch gekennzeichnet, daß die vorgenannte offene Schleife einen ununterbrochenen elektrischen Pfad zwischen ihren ersten und zweiten Enden (47, 48) bildet, daß das zweite Ende (48) dieser Schleife elektrisch mitvorgenannter Spannungsabgreifklemme (26) verbunden ist und daß die vorgenannte erste Spannungsabgreifklemme (26) und das erste Ende (47) der vorgenannten Schleife entweder die besagten ersten und zweiten Meßklemmen (56a, 56b) bilden oder jeweils mit diesen verbunden sind.

3. Meßwiderstand nach Anspruch 1 oder 2, dadurch gekennzeichnet, daß die Induktivität zwei offene Schleifen in Form eines U (36a, 36b) umfaßt, die einander zugewandt, auf den gegenüberliegenden Flächen der vorgenannten Platte (12), die den Widerstand bildet, angeordnet sind, un beide offene Schleifen physikalisch über ihre ersten und zweiten Enden (47, 48) jeweils verbunden sind und eine einstückige Klammer bilden.

4. Meßwiderstand nach Anspruch 3, dadurch gekennzeichnet, daß die die Induktivität bildende Klammer aus federndem, elektrisch leitenden Material besteht, die auf die Platte (12) geklemmt wird.

5. Meßwiderstand nach Anspruch 4, dadurch gekennzeichnet, daß das besagte federnde Material eine Bronze-Beryllium-Legierung ist.

6. Meßwiderstand nach Anspruch 1, dadurch gekennzeichnet, daß die besagte offene Schleife durch zwei konvergierende Teile (58a, 60a) verschiedener elektrischer Leiter, die voneinander isoliert sind, gebildet ist, wobei das Ende (58b) des ersten Teiles mit der besagten ersten Spannungsabgreifklemme (26) und das Ende (60b) des zweiten Teiles (60a) mit der vorgenannten zweiten Spannungsabgreifklemme (28) elektrisch verbunden ist und die vorgenannten Teile der Leiter zueinander in der zu ihren Enden entgegengesetzten Richtung konvergieren, welche Enden mit den Spannungsabgreifklemmen verbunden sind.

7. Meßwiderstand nach Anspruch 6, dadurch gekennzeichnet, daß die vorgenannten Teile der isolierten Leiter (58a, 60a) auf derselben Seite der Platte angeordnet sind und sich in einem gemeinsamen Punkt (66) wieder vereinen, der in der Nähe des Randes (32) der Platte liegt, der demjenigen (30) gegenüberliegt, an dem die genannten Spannungsklemmen angeordnet sind, daß die vorgenannten isolierten Leiter (58, 60) sich über besagten gemeinsamen Punkt (66) hinaus fortsetzen und miteinander verdrillt sind und daß die besagten Meßklemmen jeweils von zwei Punkten (58c, 60c) der besagten verdrillten Leiter gebildet werden.

8. Meßwiderstand nach einem der vorhergehenden Ansprüche, dadurch gekennzeichnet, daß besagte Platte (12), die die den Widerstand bildet, eine im wesentlichen rechteckige Form hat.

9. Meßwiderstand nach einem der vorhergehenden Ansprüche, dadurch gekennzeichnet, daß wenigstens besagte erste offene Schleife auf einer Seite der besagten Platte mittels eines Klebemittels angebracht ist.

Fig. 1

Fig. 2

Fig. 3

Fig. 4

Fig. 5